# EUROPÄISCHE PATENTSCHRIFT

(11) **EP 2 752 854 B1**
(45) Veröffentlichungstag und Bekanntmachung des Hinweises auf die Patenterteilung: **18.11.2015**
(21) Anmeldenummer: 13004670.9
(22) Anmeldetag: 26.09.2013
(51) Int. Cl.: G11C 16/34, H04W 4/00

(54) **Verfahren zum Betreiben eines Teilnehmeridentifikationsmoduls sowie ein solches Teilnehmeridentifikationsmodul**
Method for operating a participant identification module as well as such a participant identification module
Procédé de fonctionnement d'un module d'identification de participants et module d'identification de participants de ce type

(30) Priorität: 18.12.2012 DE 102012024772
(43) Veröffentlichungstag der Anmeldung: 09.07.2014
(73) Patentinhaber: Giesecke & Devrient GmbH, 81677 München (DE)
(72) Erfinder: Baldischweiler, Michael, 81825 München (DE)

(56) Entgegenhaltungen:
- EP-A1- 2 533 553
- US-A1- 2009 161 466

## Beschreibung

Die Erfindung betrifft ein Verfahren zum Betreiben eines Teilnehmeridentifikationsmoduls sowie ein solches Teilnehmeridentifikationsmodul. Als Teilnehmeridentifikationsmodul wird hier insbesondere ein M2M-Modul, ein SIM (subscriber identification module) oder dergleichen verstanden.

Teilnehmeridentifikationsmodule dienen dazu, einen Teilnehmer gegenüber einem Mobilfunknetzwerk zu authentisieren. Hierzu verfügt ein Teilnehmeridentifikationsmodul in der Regel über eine zentrale Prozessoreinheit (CPU; central processing unit) zur Durchführung der Authentisierung und eine Speichereinheit zur sicheren Aufbewahrung von Teilnehmeridentifikationsdaten, beispielsweise eine IMSI (international mobile subscriber identity) und ein Authentisierungsschlüssel Ki, die für eine erfolgreiche Authentisierung gegenüber dem Mobilfunknetzwerk erforderlich sind.

Teilnehmeridentifikationsmodule in Form von M2M-Modulen dienen einer Maschine-zu-Maschine-Kommunikation (M2M communication wie z. B. in EP 2 533 553 beschrieben) über ein Mobilfunknetzwerk, d.h. einer Kommunikation von "intelligenten" Maschinen untereinander und mit einem Hintergrundsystem. Dabei können M2M-Module in Zukunft in so unterschiedlichen Maschinen wie intelligenten Haushaltsgeräten, Stromzählern, Verkehrsampeln, Kraftfahrzeugen, Wetterstationen, Überwachungskameras und dergleichen eingesetzt werden. Zumindest bei einem Teil dieser Einsatzfelder können M2M-Module über einen längeren Zeitraum harschen Umweltbedingungen, insbesondere sehr hohen oder sehr niedrigen Temperaturen, ausgesetzt sein.

Dies kann insofern zum Problem werden, als die wesentlichen Komponenten des M2M-Moduls, beispielsweise die zentrale Prozessoreinheit oder die

Speichereinheit des M2M-Moduls, die in der Regel einen EEPROM-Speicher aufweist, Temperaturen, die eine vom Hersteller spezifizierte Maximaltemperatur überschreiten, nur in gewissen Grenzen ausgesetzt sein dürfen, da es ansonsten zu Fehlfunktionen dieser Komponenten und somit zu einem Ausfall des kompletten M2M-Moduls im Feld kommen kann.

Es ist bekannt, ein M2M-Modul bzw. die entsprechende M2M-Vorrichtung, in der ein M2M-Modul eingesetzt ist, mit einem Temperatursensor zu versehen, der laufend aktiv die Temperatur des M2M-Moduls im Feld misst. Mittels eines solchen Temperatursensors kann somit zum einen überwacht werden, ob die Temperaturen, denen das M2M-Modul ausgesetzt ist, eine kritische Temperatur übersteigen, sowie zum anderen die Temperatur des M2M-Moduls über lange Zeiträume verfolgt und aufgezeichnet werden. Auf der Grundlage dieser vom Temperatursensor des M2M-Moduls aufgenommenen Daten kann die verbleibende Lebensdauer des M2M-Moduls abgeschätzt werden. Falls eine solche Abschätzung ergibt, dass die verbleibende Lebensdauer des M2M-Moduls einen definierten Schwellenwert unterschreitet, kann das M2M-Modul diese Information über ein Mobilfunknetzwerk an ein Hintergrundsystem weitergeben, um eine Wartung oder einen Austausch des M2M-Moduls zu veranlassen.

Nachteilig an der bekannten Verwendung eines Temperatursensors zur Überwachung des M2M-Moduls ist, dass diese nur möglich ist, wenn der Temperatursensor und das M2M-Modul mit Strom beaufschlagt werden, d.h. mit elektrischer Energie versorgt werden. Denn andernfalls sind sowohl der Temperatursensor als auch die Software nicht verfügbar, die von der Prozessoreinheit des M2M-Moduls ausgeführt wird, um beispielsweise beim Über-/Unterschreiten einer Grenztemperatur zu reagieren und die verbleibende Lebensdauer des M2M-Moduls abzuschätzen. Es ist jedoch allein aus Kostengründen in der Regel ausgeschlossen, dass ein M2M-Modul ununterbrochen mit Strom versorgt wird.

Vor diesem Hintergrund stellt sich der vorliegenden Erfindung die Aufgabe, ein Verfahren zum Betreiben eines Teilnehmeridentifikationsmoduls sowie ein solches Teilnehmeridentifikationsmodul bereitzustellen, die eine alternative Möglichkeit zur Überwachung der Temperatur des Teilnehmeridentifikationsmoduls bieten, mittels der insbesondere auch im stromlosen Zustand des Teilnehmeridentifikationsmoduls dessen Temperatur überwacht werden kann.

Diese Aufgabe wird erfindungsgemäß durch das Verfahren zum Betreiben eines Teilnehmeridentifikationsmoduls nach Anspruch 1 gelöst. Ein entsprechendes Teilnehmeridentifikationsmodul ist Gegenstand des unabhängigen Vorrichtungsanspruchs. Vorteilhafte Weiterbildungen der Erfindung sind in den Unteransprüchen definiert.

Die Erfindung geht von der Grundüberlegung aus, die Entladung der Speicherzellen des nichtflüchtigen Speichers des Teilnehmeridentifikationsmoduls dazu zu verwenden, die Temperaturen, denen das Teilnehmeridentifikationsmodul ausgesetzt gewesen ist, und auf dieser Grundlage die verbleibende Lebensdauer des Teilnehmeridentifikationsmoduls abzuschätzen.

Auf der Basis dieses Grundgedankens wird gemäß einem ersten Aspekt der Erfindung ein Verfahren zum Betreiben eines Teilnehmeridentifikationsmoduls zur Identifikation eines Teilnehmers in einem mobilen Kommunikationsnetzwerk bereitgestellt, wobei das Teilnehmeridentifikationsmodul eine zentrale Prozessoreinheit und eine Speichereinheit mit einem auf Transistoren basierenden nichtflüchtigen, wiederbeschreibbaren Speicher umfasst. Das Verfahren umfasst die folgenden Schritte: das Messen einer ersten Ladungsmenge wenigstens einer geladenen Speicherzelle des nichtflüchtigen Speichers; optional das Speichern der ersten Ladungsmenge der wenigstens einen geladenen Speicherzelle des nichtflüchtigen Speichers; das Messen einer zweiten Ladungsmenge der wenigstens einen geladenen Speicherzelle des nichtflüchtigen Speichers zu einem späteren Zeitpunkt; das Vergleichen der erste Ladungsmenge mit der zweiten Ladungsmenge der wenigstens einen geladenen Speicherzelle; und das Benachrichtigen eines Hintergrundsystems über das mobile Kommunikationsnetzwerk in dem Fall, dass die Abweichung der ersten Ladungsmenge von der zweiten Ladungsmenge der wenigstens einen geladenen Speicherzelle größer als ein definierbarer Schwellenwert ist.

Vorzugsweise werden bei den Schritten des Messens der ersten und der zweiten Ladungsmenge jeweils die Ladungsmengen einer Vielzahl von geladenen Speicherzellen gemessen werden und hieraus ein Mittelwert gebildet und beim Schritt des Vergleichens die Mittelwerte miteinander verglichen.

Gemäß bevorzugter Ausführungsformen der Erfindung handelt es sich bei der Vielzahl von geladenen Speicherzellen um eine zufällige Auswahl der geladenen Speicherzellen des nichtflüchtigen Speichers.

Alternativ handelt es sich bei der Vielzahl von geladenen Speicherzellen um eine gezielte Auswahl der geladenen Speicherzellen des nichtflüchtigen Speichers. Dabei handelt es sich bei der gezielten Auswahl der geladenen Speicherzellen des nichtflüchtigen Speichers vorzugsweise um geladene Speicherzellen eines definierten Adressbereich des nichtflüchtigen Speichers. Vorzugsweise wird in dem Fall, dass die Abweichung der ersten Ladungsmenge von der zweiten Ladungsmenge der wenigstens einen geladenen Speicherzelle größer als ein definierbarer Schwellenwert ist, die Ladungsmenge der wenigstens einen geladenen Speicherzelle wieder aufgefüllt, d.h. ein "Refresh"-Vorgang durchgeführt. Dabei wird vorzugsweise bei jedem Widerauffüllen der wenigstens einen geladenen Speicherzelle ein "Refresh"-Zähler erhöht und das Hintergrundsystem erst dann benachrichtigt, wenn der "Refresh"-Zähler größer als ein definierbarer Schwellenwert ist.

Gemäß bevorzugter Ausführungsformen der Erfindung wird die erste Ladungsmenge der wenigstens einen geladenen Speicherzelle des nichtflüchtigen Speichers in dem Hintergrundsystem oder dem nichtflüchtigen Speicher gespeichert.

Vorzugsweise handelt es sich bei dem nichtflüchtigen Speicher um einen EEPROM-Speicher, vorzugsweise um einen Flash-Speicher.

Gemäß einem zweiten Aspekt der Erfindung wird ein Teilnehmeridentifikationsmodul zur Identifikation eines Teilnehmers in einem mobilen Kommunikationsnetzwerk bereitgestellt, wobei das Teilnehmeridentifikationsmodul eine zentrale Prozessoreinheit und eine Speichereinheit mit einem auf Transistoren basierenden nichtflüchtigen, wiederbeschreibbaren Speicher umfasst und dazu ausgestaltet ist, gemäß dem Verfahren nach einem der vorstehenden Ansprüche betrieben zu werden. Insbesondere umfasst das Teilnehmeridentifikationsmodul eine geeignet ausgestaltet Messeinrichtung zur Messung der Ladungsmenge wenigstens einer Speicherzelle des nichtflüchtigen Speichers. Dabei ist die Auflösung der Messeinrichtung derart gewählt, dass die Messung der Ladungsmenge genauer als bis auf Bitebene erfolgt, so dass Ladungsabflüsse erkannt werden können, bevor sich die durch die Ladungsmenge repräsentierten Bitwerte ändern.

Bei einem Teilnehmeridentifikationsmodul im Sinne der vorliegenden Erfindung handelt es sich vorzugsweise um ein M2M-Modul, ein SIM (subscriber identity module) oder ein (e)UICC (embedded universal integrated circuit card).

Wie der Fachmann erkennt, lassen sich die vorstehend beschriebenen bevorzugten Ausgestaltungen sowohl im Rahmen des ersten Aspekts der Erfindung, d.h. im Rahmen des Verfahrens zum Betreiben eines Teilnehmeridentifikationsmoduls, als auch im Rahmen des zweiten Aspekts der Erfindung, d.h. im Rahmen des Teilnehmeridentifikationsmoduls, vorteilhaft implementieren.

Einer der maßgeblichen Vorteile der vorliegenden Erfindung besteht darin, dass die thermische Belastung eines Teilnehmeridentifikationsmoduls, vorzugsweise in Form eines M2M-Moduls unabhängig von dessen Versorgung mit Energie kontinuierlich erfasst wird, so dass sich Aussagen über die verbleibende Lebensdauer eines M2M-Moduls auch auf der Basis von Ereignissen machen lassen, die sich während Zeiträumen ereignet haben, in denen das M2M-Modul nicht mit Energie versorgt worden ist, d.h. stromlos gewesen ist, beispielsweise bei der Auslieferung und dem Einbau des M2M-Moduls. Mittels dieser zusätzlichen Informationen lassen sich die Ausfallzeiten durch defekte M2M-Module verringern, da genauere Abschätzungen der verbleibenden Lebensdauer von M2M-Modulen möglich sind. Die genauere Abschätzung der verbleibenden Lebensdauer eines M2M-Moduls liefert den weiteren Vorteil, dass sich diese Lebensdauer besser ausnutzen lässt. Ein weiterer Vorteil der Erfindung besteht darin, dass die "indirekte" Temperaturmessung genau dort erfolgt, wo eine mögliche Fehlfunktion zum Ausfall des M2M-Moduls führen würde, nämlich in der Speichereinheit, und nicht, wie im Stand der Technik, mittels eines "externen", von der Speichereinheit unabhängigen Temperatursensors.

Weitere Merkmale, Vorteile und Aufgaben der Erfindung gehen aus der folgenden detaillierten Beschreibung mehrerer Ausführungsbeispiele und Ausführungsalternativen hervor. Es wird auf die Zeichnungen verwiesen, in denen zeigen:
- Fig. 1: eine schematische Darstellung einer bevorzugten Ausführungsform eines erfindungsgemäßen Teilnehmeridentifikationsmoduls in Form eines M2M-Moduls, das über ein Mobilfunknetzwerk in Kommunikation mit einem Hintergrundsystem steht,
- Fig. 2: eine schematische Detaildarstellung der Speichereinheit des Teilnehmeridentifikationsmoduls von Figur 1, und
- Fig. 3: eine tabellarische Darstellung von Größen, die gemäß dem erfindungsgemäßen Verfahren zur Abschätzung der verbleibenden Lebensdauer eines M2M-Moduls bestimmt und hinterlegt werden.

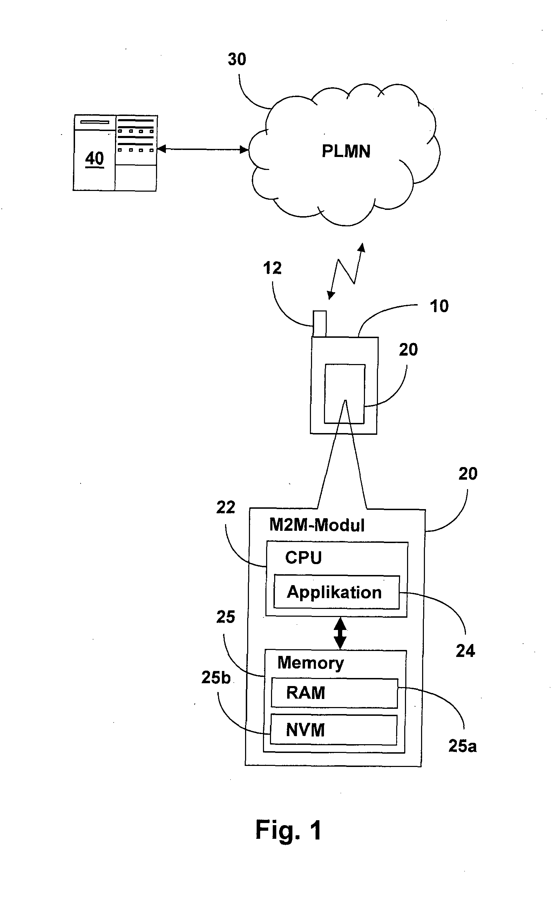

Figur 1 zeigt eine schematische Darstellung einer bevorzugten Ausführungsform eines erfindungsgemäßen Teilnehmeridentifikationsmoduls in Form eines M2M-Moduls 20, das Teil einer M2M-Vorrichtung 10 ist. Die M2M-Vorrichtung 10, bei der es sich beispielsweise um ein Kraftfahrzeug, eine Wetterstation, eine Überwachungskamera, ein Mobiltelefon oder dergleichen handeln kann, ist dazu ausgestaltet über ein Mobilfunknetzwerk oder PLMN (public land mobile network) 30 mit anderen M2M-Vorrichtungen (nicht dargestellt) und einem Hintergrundsystem 40 zu kommunizieren. Hierzu verfügt die M2M-Vorrichtung 10 über eine geeignete Kommunikationsschnittstelle 12, die beispielsweise einen Transceiver umfassen kann.

Das M2M-Modul 20 ist dazu ausgestaltet, mit der M2M-Vorrichtung 10 Daten auszutauschen. Hierzu verfügt die M2M-Vorrichtung 10 in der Regel über ein geeignetes Lesegerät, in welches das M2M-Modul 20 derart eingesteckt ist, dass Kontaktflächen des M2M-Moduls 20 mit entsprechenden Kontaktflächen des Lesegeräts der M2M-Vorrichtung 10 galvanisch in Kontakt sind. Alternativ kann das M2M-Modul 20 auch fester Bestandteil der M2M-Vorrichtung 10 sein.

Wie sich dies der Detaildarstellung des M2M-Moduls 20 in Figur 1 entnehmen lässt, umfasst das M2M-Modul 20 eine zentrale Prozessor- bzw. Recheneinheit (CPU; central processing unit) 22 und eine Speichereinheit (memory) 25, die einen flüchtigen Speicher (RAM; random access memory) 25a und einen auf Transistoren basierenden, nichtflüchtigen wieder beschreibbaren Speicher (NVM; non-volatile memory) 25b aufweist. Vorzugsweise handelt es sich bei dem auf Transistoren basierenden, nichtflüchtigen Speicher 25b um einen EEPROM-Speicher und weiter bevorzugt um einen Flash-Speicher. Wie dies dem Fachmann bekannt ist, kann die Kommunikation zwischen der zentralen Prozessoreinheit 22 und der Speichereinheit 25 des M2M-Moduls 20 beispielsweise über ein oder mehrere Bussysteme erfolgen, wie dies in Figur 1 schematisch durch einen Doppelpfeil angedeutet ist. Falls das M2M-Modul 20 fester Bestandteil der M2M-Vorrichtung 10 ist, kann auch die Kommunikation zwischen dem M2M-Modul 20 und den elektronischen Bauelementen der M2M-Vorrichtung 10 über ein oder mehrere Bussysteme erfolgen.

Vorzugsweise ist die zentrale Prozessoreinheit 22 des M2M-Moduls 20 derart ausgestaltet, dass auf dieser eine Applikation 24 ausgeführt werden kann, welche die zentrale Prozessoreinheit 22 dazu veranlasst, den nachstehend im Detail beschriebenen erfindungsgemäßen Mechanismus zur Bestimmung der Temperaturen, denen das M2M-Modul 20 in der Vergangenheit ausgesetzt gewesen ist, und zur Abschätzung der verbleibenden Lebensdauer des M2M-Moduls 20 durchzuführen.

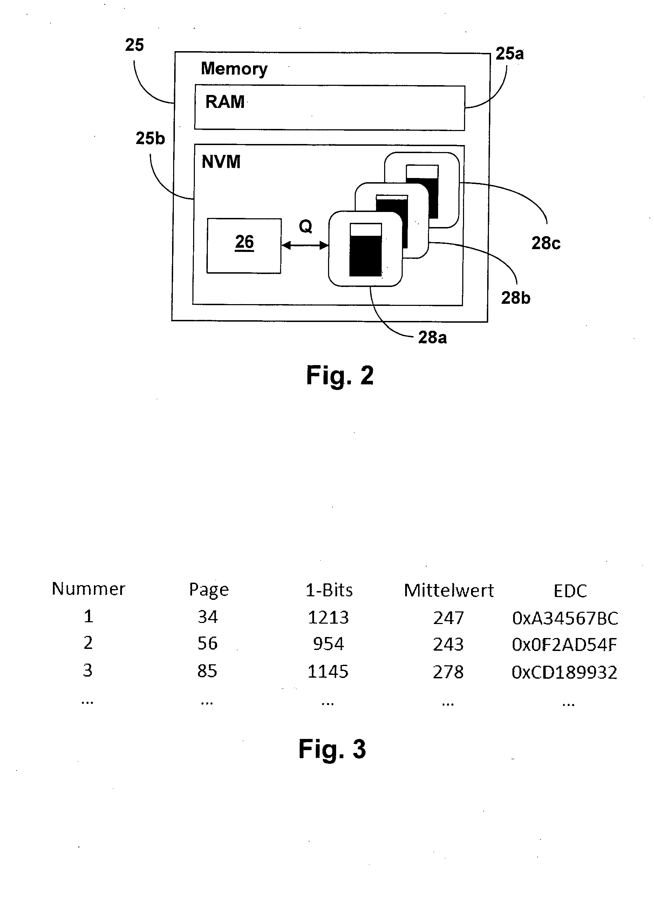

Figur 2 zeigt eine schematische Detaildarstellung der Speichereinheit 25 des M2M-Moduls 20. Wie bereits vorstehend beschrieben, weist die Speichereinheit 25 neben einem flüchtigen Arbeitsspeicher (RAM) 25a einen auf Transistoren basierenden, nichtflüchtigen wieder beschreibbaren Speicher 25b auf, bei dem es sich vorzugsweise um einen EEPROM-Speicher, noch weiter bevorzugt um einen Flash-Speicher handelt. In dem nichtflüchtigen Speicher 25b könnten beispielsweise ein Betriebssystem für das M2M-Modul, der Programmcode der Applikation 24 und/ oder Teilnehmeridentifikationsdaten zur Authentisierung gegenüber dem Mobilfunknetzwerk 30 hinterlegt sein, beispielsweise eine IMSI (international mobile subscriber identity) und ein Authentisierungsschlüssel Kᵢ. Selbstverständlich kann die Speichereinheit 25 auch einen Festwertspeicher (ROM; read only memory) aufweisen, um derartige Datenelemente aufzunehmen.

Vorzugsweise besteht der auf Transistoren basierende, nichtflüchtige wieder beschreibbare Speicher 25b der Speichereinheit 25 aus einer Vielzahl von Speicherzellen, von denen drei Speicherzellen, nämlich die Speicherzellen 28a-c, in Figur 2 beispielhaft dargestellt sind. Vorzugsweise umfasst jede dieser Speicherzellen 28a-c des nichtflüchtigen Speichers 25b jeweils wenigstens einen Floating-Gate-Transistor, dessen nachstehend kurz zusammengefasste Funktionsweise dem Fachmann bekannt ist. Übersteigt die auf dem Floating-Gate des Transistors vorhandene Ladung einen Schwellenwert, verbleibt die Drain-Source-Strecke des Transistors beim Auslesen in einem niederohmigen Zustand. Falls die Ladung des Floating-Gates des Transistors jedoch kleiner als dieser Schwellenwert ist, ist die Drain-Source-Strecke des Transistors hingegen hochohmig. Für weitere Details zum Aufbau und zur Funktionsweise von Floating-Gate-Transistoren sowie eines daraus aufgebauten EEPROM-Speichers wird auf Abschnitt 5.3.3 des Buches "Handbuch der Chipkarten" von Wolfgang Rankl und Wolfgang Effing, 5. Auflage verwiesen, auf das hiermit vollumfänglich Bezug genommen wird.

Mit den beiden vorstehend beschriebenen durch das Floating-Gate definierten Zuständen kann im einfachsten Fall in jeder Speicherzelle 28a-c des nichtflüchtigen Speichers 25b mittels des Floating-Gate-Transistors die Information eines Bits permanent gespeichert werden. In diesem Fall wird eine Speicherzelle als SLC-Speicherzelle (single-level cell) bezeichnet. Bei den Speicherzellen 28a-c des nichtflüchtigen Speichers 25b kann es sich jedoch auch um sogenannte MLC-Speicherzellen (multi-level cell) handeln, bei denen in einem Floating-Gate-Transistor durch Abstufungen der Ladungsmengen mehr als ein Bit an Information gespeichert werden kann, was zu einer höheren Speicherdichte führt. Üblicherweise werden in einem Floating-Gate-Transistor jedoch nicht mehr als zwei Bits gespeichert, die vier verschiedenen Ladungsniveaus entsprechen, also z.B. die logischen Zustände 00,10, 01 und 11.

Wie dies in Figur 2 schematisch dargestellt ist, umfasst der nichtflüchtige Speicher 25b wenigstens eine Messeinrichtung 26 zur Messung der Ladungsmenge Q des Floatings-Gates des Floating-Gate-Transistors wenigstens einer Speicherzelle, z.B. der Speicherzelle 28a. Im Rahmen der Erfindung ist es denkbar, dass lediglich eine Messeinrichtung 26 vorgesehen ist, die dazu ausgestaltet ist, die jeweilige Ladungsmenge des Floatings-Gates des Floating-Gate-Transistors aller Speicherzellen des nichtflüchtigen Speichers 25b zu messen. Alternativ kann erfindungsgemäß für jede Speicherzelle des nichtflüchtigen Speichers 25b eine eigene Messeinrichtung 26 zur Bestimmung der Ladungsmenge des Floatings-Gates des Floating-Gate-Transistors der entsprechenden Speicherzelle vorgesehen sein, die auch Teil der jeweiligen Speicherzelle sein kann. Wie dies in Figur 2 schematisch anhand der unterschiedlich stark gefüllten Rechtecke angedeutet ist, weisen die Floating-Gates der dort beispielhaft dargestellten Speicherzellen 28a-c unterschiedliche Ladungsmengen auf. Trotz dieser unterschiedlichen Ladungsmengen stellen jedoch alle drei Speicherzellen 28a-c denselben logischen Wert, z.B. den logischen Wert 1, dar.

Der Fachmann wird somit erkennen, dass sich die hier beschriebene Messeinrichtung 26 im Wesentlichen darin von herkömmlichen Mitteln zur Bestimmung des Ladungszustands (logisch 0 oder logisch 1) einer auf einem Floating-Gate-Transistor basierenden Speicherzelle unterscheidet, dass die Messeinrichtung 26 dazu ausgestaltet ist, die tatsächliche Ladungsmenge einer Speicherzelle (genauer des Floating-Gates des Transistors einer Speicherzelle) mit einer hohen Genauigkeit und Auflösung zu bestimmen. Vorzugsweise ist die Auflösung der Messeinrichtung 26 derart, dass der Bereich zwischen einem maximalen Ladungsniveau und einem minimalen Ladungsniveau in mindestens 10, vorzugsweise mindestens 50 und noch weiter bevorzugt mindestens 100 Messbereiche bzw. Ladungsstufen aufgelöst wird.

Beim Einsatz der M2M-Vorrichtung 10 mit dem M2M-Modul 20 im Feld werden das M2M-Modul 20 und dessen Speichereinheit 25 Umweltbedingungen ausgesetzt sein, die einen Einfluss auf das M2M-Modul 20 haben. So hängt die Entladungsrate, d.h. die Änderung der Ladungsmenge pro Zeiteinheit, des Floating-Gates des Transistors einer Speicherzelle 28a-c des nichtflüchtigen Speichers 25b der Speichereinheit 25 zu einem großen Teil von der Temperatur des M2M-Moduls 20 ab. Bei Floating-Gate-Transistoren nimmt die Entladungsrate des Floating-Gates sowohl bei sehr niedrigen als auch bei sehr hohen Temperaturen stark zu, wobei die Abhängigkeit der Entladungsrate des Floating-Gates von dessen Temperatur zu hohen Temperaturen hin in der Regel bedeutend stärker als linear, d.h. superlinear ansteigt. Dies äußert sich beispielsweise darin, dass z.B. ein ursprünglich vollständig geladenes Floating-Gate eines Floating-Gate-Transistors einer Speicherzelle bei einer Temperatur von 100°C nach ungefähr 24 Stunden, bei einer Temperatur von 200°C jedoch bereits nach 5 Minuten entladen sein kann. Speicher mit anderen Transistoraufbauten haben andere Entladezeiten.

Wie dies im vorstehend erwähnten Buch "Handbuch der Chipkarten" im Detail beschrieben wird, basiert die Entladung des Floating-Gates des Floating-Gate-Transistors einer Speicherzelle des nichtflüchtigen Speichers 25b auf physikalischen, insbesondere quantenmechanischen Effekten, die unabhängig davon auftreten, ob das M2M-Modul 20 mit Strom bzw. Energie versorgt wird oder nicht. Folglich beeinflussen auch im ausgeschalteten, d.h. stromlosen Zustand der M2M-Vorrichtung 10 Phasen extremer Temperaturen die Entladungsrate und somit die Ladungsmenge der jeweiligen Floating-Gates der Floating-Gate-Transistoren der Speicherzellen 28a-c des nichtflüchtigen Speichers 25b.

Bei dem erfindungsgemäßen M2M-Modul 20 ist nun vorgesehen, dass beispielsweise nach dessen Initialisierung/Personalisierung und/ oder vor dessen Auslieferung an einen Kunden bzw. vor dessen Einsatz im Feld die Ladungsmengen der Floating-Gates der Floating-Gate-Transistoren vorzugsweise einer Vielzahl von geladen Speicherzellen, beispielsweise der geladenen Speicherzellen 28a-c, des nichtflüchtigen Speichers 25b gemessen werden. Diese Messung der Ladungsmengen der Floating-Gates einer Vielzahl von geladen Speicherzellen erfolgt mittels der Messeinrichtung 26 bzw. einer entsprechenden Vielzahl solcher Messeinrichtungen. Unter einer geladenen Speicherzelle wird hierbei eine Speicherzelle verstanden, der bei einem vorhergehenden Speichern von Daten Ladung zugeführt worden ist, um ein Bit dieser Daten zu repräsentieren, also in der Regel eine Speicherzelle, in welcher der logische Wert 1 gespeichert ist.

Bei der Vielzahl von geladenen Speicherzellen kann es sich um eine zufällige oder eine gezielte Auswahl von geladenen Speicherzellen des nichtflüchtigen Speichers 25b der Speichereinheit 25 des M2M-Moduls 20 oder auch um alle geladenen Speicherzellen des nichtflüchtigen Speichers 25b handeln. Vorzugsweise handelt sich bei der Vielzahl von geladenen Speicherzellen um die geladenen Speicherzeilen eines definierten Bereichs des nichtflüchtigen Speichers 25b der Speichereinheit 25 des M2M-Moduls 20. Beispielsweise kann es sich bei der Vielzahl von geladenen Speicherzellen um eine definierte Anzahl von Speicherzellen handeln, die bei einer bestimmten Adresse des nichtflüchtigen Speichers 25b starten (z.B. die Speicherzelle mit der Adresse XYZ sowie die darauf folgenden 999 Speicherzellen), oder im bevorzugten Fall, dass der nichtflüchtige Speicher 25b als Flash-Speicher vorliegt, um die Speicherzellen von einer oder mehreren definierten Seiten bzw. Pages des Flash-Speichers handeln. Eine gezielte Auswahl von geladenen Speicherzellen des nichtflüchtigen Speichers 25b der Speichereinheit 25 des M2M-Moduls 20 kann beispielsweise dadurch getroffen werden, dass in einer ersten Messung die Ladungsmengen vorzugsweise von allen Speicherzellen des nichtflüchtigen Speichers 25b gemessen werden und die geladenen Speicherzellen ausgewählt werden, für die bei einer anschließenden zweiten Messung bereits ein beträchtlicher Ladungsverlust festgestellt wird, d.h. ein Ladungsverlust, der größer als ein definierter Schwellenwert ist.

In dem nachstehend unter weiterer Bezugnahme auf Figur 3 beschriebenen bevorzugten Beispiel ist der nichtflüchtige Speicher 25b der Speichereinheit 25 als Flash-Speicher mit einer Vielzahl von Seiten bzw. Pages ausgestaltet, die jeweils eine Vielzahl von Speicherzellen aufweisen. Anstatt die für die Vielzahl von geladenen Speicherzellen gemessenen Ladungsmengen im nichtflüchtigen Speicher 25b der Speichereinheit 25 des M2M-Moduls 20 selbst und/oder im Hintergrundsystem 40 in Verbindung mit einem eindeutigen Identifikationselement des M2M-Moduls 20, beispielsweise einer IMSI (international mobile subscriber identity) oder ICCID (integrated circuit card identification), zu hinterlegen, was erfindungsgemäß ebenfalls denkbar ist, werden zur Reduzierung der zu speichernden Datenmenge die für die Vielzahl von geladenen Speicherzellen gemessenen Ladungsmengen mittels eines geeigneten Verfahrens zur Bildung eines Mittelwerts zunächst gemittelt. Vorzugsweise wird dieser Mittelwert über die geladenen Speicherzellen einer Seite bzw. Page des als Flash-Speicher ausgestalteten Speichers 25b gebildet und zusammen mit der Anzahl der gemessenen geladenen Speicherzellen ("1-Bits"), der Adresse des Speicherbereichs bzw. der Index der Flash-Page sowie einem Error Detection Code (EDC) über die vorangegangenen Daten im nichtflüchtigen Speicher 25b des M2M-Moduls 20 selbst abgelegt. Vorzugsweise werden zur Vermeidung von statistischen Schwankungen mehrere Mittelwerte über unterschiedliche Mengen von Speicherzellen gebildet. Eine entsprechende Tabelle zeigt Figur 3, die beispielhaft die folgenden Spalten aufweist: eine fortlaufende Nummer zur Kennzeichnung eines Speicherbereichs bzw. einer Messung, die Page-Nummer, die Anzahl der geladenen Speicherzellen, also z.B. die Anzahl der Bits mit dem logischen Wert 1 ("1-Bits") auf der entsprechenden Page, der Mittelwert der für diese geladenen Speicherzellen gemessenen Ladungsmengen (in beliebigen Einheiten) sowie ein Fehlererkennungscode (EDC; error detection code) in Hexadezimaldarstellung. Vorzugsweise wird der Fehlererkennungscode über einige oder alle in der entsprechenden Zeile stehenden Werte gebildet, insbesondere über den berechneten Mittelwert der Ladungsmengen der geladenen Speicherzellen. Wie dies dem Fachmann bekannt ist, erlaubt der Fehlererkennungscode bei einem späteren Zugriff das Erkennen von Speicherfehlern bei den Daten, die in den Fehlererkennungscode einfließen. Zusätzlich oder alternativ kann die in Figur 3 dargestellte Tabelle oder eine ähnliche Tabelle in Verbindung mit einem eindeutigen Identifikationselement des M2M-Moduls 20, beispielsweise der IMSI oder der ICCID, im Hintergrundsystem 40 hinterlegt werden.

Die Spalte mit der Anzahl der geladenen Speicherzellen, also üblicherweise die Anzahl der Speicherzellen mit dem logischen Wert 1 ("1-Bits"), wird dazu verwendet, um bei nachfolgenden Kontrollmessungen prüfen zu können, ob nicht bereits eine oder mehrere dieser geladenen Speicherzellen (logisch 1) durch Ladungsverluste in den entladenen Zustand (logisch 0) zurückgefallen sind. Sollte dies der Fall sein, wird erfindungsgemäß die Berechnung des Mittelwerts der Ladungsmengen entsprechend angepasst. Ferner wird der Fachmann erkennen, dass, falls die Ladungszustände einer oder mehrerer Speicherzellen, deren Ladungsmengen in die Berechnung eines Mittelwerts eingeflossen sind, verändert werden, beispielsweise mit dem logischen Wert 0 beschrieben werden, der entsprechende Eintrag in der in Figur 3 dargestellten beispielhaften Tabelle angepasst und bei der Berechnung eines neues Mittelwerts berücksichtigt werden muss.

Für den Fall, dass es sich bei dem nichtflüchtigen Speicher 25b der Speichereinheit 25 des M2M-Moduls 20 um den bevorzugten Fall eines Flash-Speichers handelt, bei dem mehrere Speicherzellen zu einer Seiten bzw. Page des Flash-Speichers zusammengefasst sind, die bekanntermaßen immer nur gemeinsam geschrieben werden können und bei denen beim Löschen einer Seite alle Speicherzellen wieder den logischen Wert 1 erhalten und somit Ladungsverluste durch ein Wiederaufstellen aller Bits rückgängig gemacht werden können, ist es empfehlenswert, für die Messung der Ladungsmengen einer Vielzahl von Speicherzellen die Seiten des Flash-Speichers zu verwenden, die statische, d.h. unveränderliche Daten enthalten, wie beispielsweise ein Betriebssystem des M2M-Moduls 20.

Nach der vorstehend beschriebenen ersten "Eichmessung" der Ladungsmengen einer Vielzahl von geladenen Speicherzellen und der Hinterlegung der vorstehend beschriebenen und in Figur 3 dargestellten Daten ist nun erfindungsgemäß vorgesehen, dass in bestimmten Abständen, die regelmäßig oder unregelmäßig sein können, z.B. bei jedem n-ten Anschalten der M2M-Vorrichtung 10 oder bei jedem m-ten Zugriff auf den nichtflüchtigen Speicher 25b der Speichereinheit 25 des M2M-Moduls 20, die Messung der Ladungsmengen der Vielzahl von Speicherzellen wiederholt wird und mit den vorhergehenden Ergebnissen in Beziehung gesetzt wird, um insbesondere eine Abschätzung der verbleibenden Lebensdauer des M2M-Moduls 20 machen zu können.

Hierzu wird im Wesentlichen wie vorstehend beschrieben vorgegangen, d.h. für die bei einer ersten Messung definierte Vielzahl von Speicherzellen wird die Ladungsmenge einer jeweiligen Speicherzelle bestimmt und daraus ein Mittelwert gebildet. Wird hierbei festgestellt, dass die Differenz zwischen einem aktuell gemessenen Mittelwert und einem gespeicherten Mittelwert der Ladungsmengen einer Vielzahl von geladenen Speicherzellen, beispielsweise einer Seite bzw. Page des als Flash-Speichers ausgestalteten nichtflüchtigen Speichers 25b, größer als ein definierbarer Schwellenwert ist, lässt sich daraus schließen, dass die betreffenden Speicherzellen seit der letzten Messung beträchtliche Ladungsverluste erlitten haben, die dadurch hervorgerufen worden sein können, dass das M2M-Modul 20 in der Zwischenzeit extremen Temperaturen ausgesetzt gewesen ist, und zwar sowohl im Betrieb als auch im stromlosen Zustand des M2M-Moduls 20.

Falls festgestellt wird, dass die Differenz zwischen den aktuell gemessenen Mittelwerten und den gespeicherten Mittelwerten, größer als ein definierbarer Schwellenwert ist, kann erfindungsgemäß vorgesehen sein, um Datenverluste zu vermeiden, die Ladungen der Vielzahl von geladenen Speicherzellen wieder aufzufüllen, indem beispielsweise eine entsprechende Seite bzw. Page des als Flash-Speicher ausgestalteten nichtflüchtigen Speichers 25b gelöscht und neu beschrieben wird, und zwar üblicherweise atomar. Vorzugsweise geschieht dies noch mit weiteren Pages, ggf. sogar mit dem gesamten als Flash-Speicher ausgestalteten nichtflüchtigen Speicher 25b des M2M-Moduls 20. Dieser Mechanismus ist prinzipiell aus dem Stand der Technik als "Refresh"-Mechanismus bekannt.

Erfindungsgemäß wird bei jedem derartigen "Refresh"-Vorgang ein "Refresh"-Zähler erhöht, der somit anzeigt, wie oft die Ladungsmengen der Vielzahl von geladenen Speicherzellen des Speichers 25b wieder aufgefüllt worden sind bzw. wie oft das M2M-Modul 20 einer extremen thermischen Belastung ausgesetzt gewesen ist. Erreicht der "Refresh"-Zähler einen definierbaren Schwellenwert, z.B. 3,5 oder 10 "Refresh"-Vorgänge, ist in absehbarer Zeit mit einem Ausfall des M2M-Moduls 20 zu rechnen. Vorzugsweise wird in diesem Fall das Hintergrundsystem 40 über das Mobilfunknetzwerk 30 entsprechend benachrichtigt, das daraufhin vorzugsweise eine Wartung oder einen Austausch des M2M-Moduls 20 anstößt. Dabei kann, wie dies der Fachmann erkennt, der definierbare Schwellenwert der maximalen Anzahl von "Refresh"-Vorgängen empirisch oder theoretisch bestimmt werden. Wie bereits vorstehend beschrieben, kann gemäß einer erfindungsgemäßen Variante vorgesehen sein, dass die Daten sowie der "Refresh"-Zähler nicht im M2M-Modul 20 selbst, sondern im Hintergrundsystem 40 vorgehalten bzw. gepflegt werden. Diese alternative Ausgestaltung bietet zum einen den Vorteil, dass durch diese Daten kein Speicherplatz im M2M-Modul 20 verbraucht wird, und zum anderen den Vorteil, dass die Daten nicht den potentiell widrigen Umweltbedingungen ausgesetzt sind, denen das M2M-Modul 20 ausgesetzt ist und somit weniger fehleranfällig sind.

Obgleich die vorstehend beschriebene bevorzugte Ausführungsform ein Teilnehmeridentifikationsmodul in Form eines M2M-Moduls betrifft, wird der Fachmann erkennen, dass die Erfindung ebenso bei anderen Teilnehmeridentifikationsmodulen eingesetzt werden kann, wie beispielsweise einem SIM, (e)UICC und dergleichen, die eine auf Transistoren basierende nichtflüchtige Speichereinheit aufweisen und dazu ausgestaltet sind, über ein Mobilfunknetzwerk zu kommunizieren.

## Patentansprüche

1. Verfahren zum Betreiben eines Teilnehmeridentifikationsmoduls (20) zur Identifikation eines Teilnehmers in einem mobilen Kommunikationsnetzwerk (30), wobei das Teilnehmeridentifikationsmodul (20) eine zentrale Prozessoreinheit (22) und eine Speichereinheit (25) mit einem auf Transistoren basierenden nichtflüchtigen, wiederbeschreibbaren Speicher (25b) umfasst, wobei das Verfahren die folgenden Schritte umfasst:
das Messen einer ersten Ladungsmenge wenigstens einer geladenen Speicherzelle (28a-c) des nichtflüchtigen Speichers (25b);
das Messen einer zweiten Ladungsmenge der wenigstens einen geladenen Speicherzelle (28a-c) des nichtflüchtigen Speichers (25b) zu einem späteren Zeitpunkt;
das Vergleichen der erste Ladungsmenge mit der zweiten Ladungsmenge der wenigstens einen geladenen Speicherzelle (28a-c); und
das Benachrichtigen eines Hintergrundsystems (40) über das mobile Kommunikationsnetzwerk (30) in dem Fall, dass die Abweichung der ersten Ladungsmenge von der zweiten Ladungsmenge der wenigstens einen geladenen Speicherzelle (28a-c) größer als ein definierbarer Schwellenwert ist.

2. Verfahren nach Anspruch 1, wobei bei den Schritten des Messens der ersten und der zweiten Ladungsmenge jeweils die Ladungsmengen einer Vielzahl von geladenen Speicherzellen (28a-c) gemessen werden und hieraus ein Mittelwert gebildet wird und beim Schritt des Vergleichens die Mittelwerte miteinander verglichen werden.

3. Verfahren nach Anspruch 2, wobei es sich bei der Vielzahl von geladenen Speicherzellen (28a-c) um eine zufällige Auswahl der geladenen Speicherzellen des nichtflüchtigen Speichers (25b) handelt.

4. Verfahren nach Anspruch 2, wobei es sich bei der Vielzahl von geladenen Speicherzellen (28a-c) um eine gezielte Auswahl der geladenen Speicherzellen des nichtflüchtigen Speichers (25b) handelt.

5. Verfahren nach Anspruch 4, wobei es sich bei der gezielten Auswahl der geladenen Speicherzellen des nichtflüchtigen Speichers (25b) um geladene Speicherzellen eines definierten Adressbereichs des nichtflüchtigen Speichers (25b) handelt.

6. Verfahren nach Anspruch 1, wobei in dem Fall, dass die Abweichung der ersten Ladungsmenge von der zweiten Ladungsmenge der wenigstens einen geladenen Speicherzelle (28a-c) größer als ein definierbarer Schwellenwert ist, die Ladungsmenge der wenigstens einen geladenen Speicherzelle (28a-c) wieder aufgefüllt wird.

7. Verfahren nach Anspruch 6, wobei bei jedem Widerauffüllen der wenigstens einen geladenen Speicherzelle (28a-c) ein "Refresh"-Zähler erhöht wird und das Hintergrundsystem (40) erst dann benachrichtigt wird, wenn der "Refresh"-Zähler größer als ein definierbarer Schwellenwert ist.

8. Verfahren nach Anspruch 1, wobei die erste Ladungsmenge der wenigstens einen geladenen Speicherzelle (28a-c) des nichtflüchtigen Speichers (25b) in dem Hintergrundsystem (40) oder dem nichtflüchtigen Speicher (25b) gespeichert wird.

9. Verfahren nach Anspruch 1, wobei es sich bei dem nichtflüchtigen Speicher (25b) um einen EEPROM-Speicher, vorzugsweise um einen Flash-Speicher handelt.

10. Teilnehmeridentifikationsmodul (20) zur Identifikation eines Teilnehmers in einem mobilen Kommunikationsnetzwerk (30), wobei das Teilnehmeridentifikationsmodul (20) eine zentrale Prozessoreinheit (22) und eine Speichereinheit (25) mit einem auf Transistoren basierenden nichtflüchtigen, wiederbeschreibbaren Speicher (25b) umfasst, das dazu ausgestaltet ist, gemäß dem Verfahren nach einem der vorstehenden Ansprüche betrieben zu werden.

## Claims

1. A method for operating a subscriber identification module (20) for identifying a subscriber in a mobile communication network (30), wherein the subscriber identification module (20) comprises a central processor unit (22) and a memory unit (25) with a nonvolatile, rewritable memory (25b) based on transistors, wherein the method comprises the following steps of:
measuring a first charge quantity of at least one charged memory cell (28a-c) of the nonvolatile memory (25b);
measuring a second charge quantity of the at least one charged memory cell (28a-c) of the nonvolatile memory (25b) at a later time;
comparing the first charge quantity to the second charge quantity of the at least one charged memory cell (28a-c);
notifying a background system (40) via the mobile communication network (30) in the case that the deviation of the first charge quantity from the second charge quantity of the at least one charged memory cell (28a-c) is greater than a definable threshold value.

2. The method according to claim 1, wherein in the steps of measuring the first and the second charge quantity respectively the charge quantities of a multiplicity of charged memory cells (28a-c) are measured and an average value is formed therefrom, and in the step of comparing the average values are compared to each other.

3. The method according to claim 2, wherein the multiplicity of charged memory cells (28a-c) is a random selection of the charged memory cells of the nonvolatile memory (25b).

4. The method according to claim 2, wherein the multiplicity of charged memory cells (28a-c) is a targeted selection of the charged memory cells of the nonvolatile memory (25b).

5. The method according to claim 4, wherein the targeted selection of the charged memory cells of the nonvolatile memory (25b) concerns charged memory cells of a defined address range of the nonvolatile memory (25b).

6. The method according to claim 1, wherein in the case that the deviation of the first charge quantity from the second charge quantity of the at least one charged memory cell (28a-c) is greater than a definable threshold value, the charge quantity of the at least one charged memory cell (28a-c) is topped up.

7. The method according to claim 6, wherein upon each topping up of the at least one charged memory cell (28a-c) a "refresh" counter is incremented and the background system (40) is notified only when the "refresh" counter is greater than a definable threshold value.

8. The method according to claim 1, wherein the first charge quantity of the at least one charged memory cell (28a-c) of the nonvolatile memory (25b) is stored in the background system (40) or the nonvolatile memory (25b).

9. The method according to claim 1, wherein the nonvolatile memory (25b) is an EEPROM memory, preferably a flash memory.

10. A subscriber identification module (20) for identifying a subscriber in a mobile communication network (30), wherein the subscriber identification module (20) comprises a central processor unit (22) and a memory unit (25) with a nonvolatile, rewritable memory (25b) based on transistors, said subscriber identification module being configured to be operated in accordance with the method according to any of the preceding claims.

## Revendications

1. Procédé d'exploitation d'un module d'identification d'abonné (20), destiné à l'identification d'un abonné dans un réseau de communication mobile (30) le module d'identification d'abonné (20) comprenant une unité de processeur (22) centrale et une unité de mémoire (25) dotée d'une mémoire (25b) réinscriptible non volatile basée sur des transistor, le procédé comprenant les étapes suivantes:
la mesure d'une première quantité de charge d'au moins une cellule mémoire chargée (28a-c) de la mémoire (25b) non volatile;
la mesure d'une deuxième quantité de charge de la moins une cellule mémoire chargée (28a-c) de la mémoire (25b) non volatile à un moment ultérieur;
la comparaison de la première quantité de charge avec la deuxième quantité de charge de la moins une cellule mémoire chargée (28a-c); et
la notification à un système d'arrière-plan (40), par le biais du réseau de communication mobile (30), dans le cas où l'écart entre la première quantité de charge et la deuxième quantité de charge de la moins une cellule mémoire chargée (28a-c) est supérieur à une valeur seuil définissable.

2. Procédé selon la revendication 1, les quantités de charge d'une pluralité de cellules mémoire chargées (28a-c) étant, aux étapes de la mesure de la première et de la deuxième quantité de charge, respectivement mesurées, et une valeur moyenne étant formée à partir de cela, et, à l'étape de la comparaison, les valeurs moyennes étant comparées entre elles.

3. Procédé selon la revendication 2, la pluralité de cellules mémoire chargées (28a-c) consistant en une sélection aléatoire des cellules mémoire chargées de la mémoire (25b) non volatile.

4. Procédé selon la revendication 2, la pluralité de cellules mémoire chargées (28a-c) consistant en une sélection ciblée des cellules mémoire chargées de la mémoire (25b) non volatile.

5. Procédé selon la revendication 4, la sélection ciblée des cellules mémoire chargées de la mémoire (25b) non volatile consistant en des cellules mémoire chargées d'une zone d'adresses définie de la mémoire (25b) non volatile.

6. Procédé selon la revendication 1, la quantité de charge de la au moins une cellule mémoire chargée (28a-c) étant ré-remplie dans le cas où où l'écart entre la première quantité de charge et la deuxième quantité de charge de la moins une cellule mémoire chargée (28a-c) est supérieure à une valeur seuil définissable.

7. Procédé selon la revendication 6, un compteur « refresh » étant, à chaque ré-remplissage de la au moins une cellule mémoire chargée (28a-c), rehaussé, et le système d'arrière-plan (40) n'étant notifié qu'une fois que le compteur « refresh » est plus haut qu'une valeur seuil définissable.

8. Procédé selon la revendication 1, la première quantité de charge de la moins une cellule mémoire chargée (28a-c) de la mémoire (25b) non volatile étant mémorisée dans le système d'arrière-plan (40) ou dans la mémoire (25b) non volatile.

9. Procédé selon la revendication 1, la mémoire (25b) non volatile consistant en une mémoire EEPROM, de préférence en une mémoire flash.

10. Module d'identification d'abonné (20), destiné à l'identification d'un abonné dans un réseau de communication mobile (30), le module d'identification d'abonné (20) comprenant une unité de processeur (22) centrale et une unité de mémoire (25) dotée d'une mémoire (25b) réinscriptible non volatile basée sur des transistors, qui est conçu pour être exploité suivant le procédé selon une des revendications précédentes.
